**Europäisches Patentamt**

**European Patent Office**

**Office européen des brevets**

(19)

(11) Veröffentlichungsnummer : **0 333 017 B1**

# (12) EUROPÄISCHE PATENTSCHRIFT

(45) Veröffentlichungstag der Patentschrift :
**29.01.92 Patentblatt 92/05**

(51) Int. Cl.$^5$ : **G01N 21/31**, G01J 3/28

(21) Anmeldenummer : **89104132.9**

(22) Anmeldetag : **08.03.89**

(54) Verfahren zur optischen Konzentrationsmessung.

(30) Priorität : **17.03.88 DE 3809013**

(43) Veröffentlichungstag der Anmeldung :
**20.09.89 Patentblatt 89/38**

(45) Bekanntmachung des Hinweises auf die
Patenterteilung :
**29.01.92 Patentblatt 92/05**

(84) Benannte Vertragsstaaten :
**DE FR GB IT NL**

(56) Entgegenhaltungen :
US-A- 4 267 572
US-A- 4 484 817

(56) Entgegenhaltungen :
US-A- 4 560 275
US-A- 4 677 289
**PATENT ABSTRACTS OF JAPAN, Band 9, Nr.
37 (P-335)[1760], 16. Februar 1985, Seite 142 P
335 & JP-A-59-180 310**
**PATENT ABSTRACTS OF JAPAN, Band 6, Nr.
217 (P-152)[1095], 30. Oktober 1982, Seite 36 P
152 & JP-A-57-120 829**

(73) Patentinhaber : **SIEMENS
AKTIENGESELLSCHAFT
Wittelsbacherplatz 2
W-8000 München 2 (DE)**

(72) Erfinder : **Müller, Rudolf, Prof. Dr.
Ahornweg 22
W-8135 Söcking (DE)**

## Beschreibung

Die Erfindung betrifft ein Verfahren zur optischen Bestimmung der Konzentration mindestens eines Stoffes, welche direkt über eine Eigenfarbe des oder der Stoffe oder indirekt mit Hilfe eines Farbindikators in einem Medium beobachtbar ist.

Zur exakten Bestimmung der Konzentration eines Stoffes zum Beispiel in einem flüssigen Medium können viele verschiedene physikalisch-chemische Methoden angewandt werden. In den meisten Fällen sind dazu jedoch aufwendige Verfahren oder komplizierte und ortsfeste Apparaturen notwendig. So sind exakte Konzentrationsmessungen meist nur im Labor möglich und werden dort mit den verschiedensten Spektrometern, Gaschromatographen, Elementaranalysatoren und vielen anderen Geräten mehr durchgeführt.

Besteht das Problem, eine Konzentration schnell oder gar außerhalb des Labors zum Beispiel in der freien Natur zu messen, so können für eine Vielzahl derartiger Messungen optische Verfahren eingesetzt werden. Diese nutzen zum Beispiel von der spezfischen Konzentration des Stoffes abhängige Färbungen des zu messenden Stoffes selbst oder eines auf diesen Stoff ansprechenden Farbindikators. Ein Beispiel für eine solche Bestimmung ist die pH-Wert-Messung über Farbindikatoren. Dies sind Stoffe, die bei einem bestimmten pH-Wert ihre Farbe ändern oder verlieren.

Da mit Hilfe eines einzelnen Indikators nur zwei pH-Bereiche unterschieden werden können, werden heute geeignete Mischungen von Indikatoren eingesetzt, die eine über einen größeren pH-Wertbereich variierende Farbtönung ergeben. Zur Bestimmung des genauen Wertes wird diese Farbtönung mit einer Farbskala verglichen und von dieser dann der pH-Wert abgelesen.

Dieses Auswerteverfahren durch Farbvergleich ist jedoch äußerst subjektiv und wird bereits durch die Anwesenheit eines weitern gefärbten Stoffes oder einer Verunreinigung (zum Beispiel bei Schmutzwasser) deutlich erschwert, wenn nicht gar unmöglich gemacht.

Aufgabe der vorliegenden Erfindung ist es daher, ein Verfahren zur Konzentrationsmessung eines Farbstoffs oder zur Bestimmung der Farbtönung eines Indikators oder eines Indikatorsystems anzugeben, welches einfach durchzuführen ist, eine objektive Auswertung erlaubt und das außerdem weniger störanfällig ist.

Diese Aufgabe wird durch ein Verfahren der eingangs genannten Art erfindungsgemäß dadurch gelöst, daß das von dem die Farbe anzeigenden Medium abgegebene Licht mittels mehrerer, in unterschiedlichen Absorptionsbereichen empfindlicher unabhängiger Photodioden gemessen wird, die Meßwerte dann in einer Mustermatrix zusammengefaßt werden, in an sich bekannter Weise nach dem Prinzip der Mustererkennung ausgewertet werden und so anhand bekannter Vergleichswerte die Konzentration des oder der Stoffe ermittelt wird. Weitere Ausgestaltungen der Erfindung sind den Unteransprüchen zu entnehmen.

Eine einfache Anwendung für dieses Verfahren stellt die Beobachtung einer unter pH-Wertänderung verlaufenden chemischen Reaktion dar. Ist diese Reaktion bei einem bestimmten pH-Wert beendet bzw. vollständig, so kann dem Reaktionsmedium, einer Lösung, ein einziger Farbindikator bzw. pH-Indikator zugefügt werden, welcher bei diesem bestimmten pH-Wert einen Farbumschlag aufweist. Das Methylorange zum Beispiel ist ein Farbstoff, der im stark sauren Bereich eine rote Farbe aufweist und bei einem pH-Wert von ca. 3 bis 4,5 in eine gelbe Farbe umschlägt. Zur Beobachtung dieser Reaktion können bereits zwei Photodioden ausreichend sein, sofern die maximale Empfindlichkeit der Dioden in den für die beiden Indikatorfarben charakteristischen Wellenlängenbereichen liegt. Dabei ist es nicht nötig, daß der jeweilige Empfindlichkeitsbereich der Dioden scharf begrenzt oder schmal ist. Die Farbzuordnung wird durch Auswertung des hier aus zwei Meßwerten bestehenden Musters vorgenommen. Da das Muster durch eine Vergleichsmessung bekannt und in einer Aus werteeinheit gespeichert ist, kann das Erkennen des Farbumschlags automatisiert und exakt reproduziert werden.

Für kompliziertere Probleme ist natürlich eine größere Anzahl in verschiedenen Wellenlängenbereichen absorbierender Photodioden nötig. In vorteilhafter Weise sind diese Photodioden auf einem einzigen elektrischen Bauteil integriert. Dadurch wird eine einfache Handhabung ermöglicht. Eine Ausführungsform der Erfindung betrifft daher die Verwendung einer sogenannten Spektrometerdiode, wie sie zum Beispiel aus W. Albertshofer, A. Gerhard, Flüssigkeitsanalyse unter Verwendung einer Spektrometerdiode, Proceedings of Sensoren-Technologie und Anwendung, Bad Nauheim, FRG, 1986, NTG-Fachberichte 93, appendix Seite 30, bekannt ist. Diese Spektrometerdiode ist durch einen Schichtaufbau aus Halbleitermaterial mit stetig veränderlichem Bandabstand realisiert. Bei Bestrahlung der Diode von der Seite mit dem größten Bandabstand dringen die Photonen so tief in den Halbleiter ein, bis sie in der Halbleiterschicht mit dem ihrer Energie entsprechenden Bandabstand absorbiert werden können. Durch einen Schrägschliff der Rückseite der Diode ist es möglich, Schottky-Kontakte auf verschiedenen Schichten anzubringen, die unterschiedliche Bandabstände aufweisen. So können die erzeugten Signale verschiedenen Wellenlängen des einfallenden Lichts zugeordnet werden.

Weiterentwicklungen dieser Spektrometerdiode hin zu höherer Empfindlichkeit sind den deutschen Patentanmeldungen P 3736201.1 und P 3743131.5 zu entnehmen, während verschiedene Verfahren zum Betrieb der Spektrometerdiode in der deutschen Anmeldung Nr. P 3736203.8 beschrieben sind.

Je nach Bauweise kann eine solche Spektrometerdiode in bis zu ca. 15 unterschiedlichen Absorptionsbereichen detektieren. Durch geeignete Betriebsverfahren, zum Beispiel durch Verändern der Betriebsspannung der Diode lassen sich die Empfindlichkeitsbereiche der einzelnen Dioden verschieben. Dadurch kann von jeder Einzeldiode mehr als ein Signal erhalten werden. Dies erhöht die Meßwertdichte, erleichtert die Auswertung und macht das Ergebnis exakter.

Das erfindungsgemäße Verfahren kann zur kontinuierlichen Beobachtung einer chemischen Reaktion eingesetzt werden, sofern einer der Reaktionspartner eine Farbe aufweist oder über einen Farbindikator nachweisbar ist. Jede Einzeldiode liefert dann ein zeit- bzw. konzentrationsabhängiges Signal, das nach mathematischen Prinzipien durch Kurvendiskussion (zum Beispiel Bildung der Ableitungen, Bestimmung der Kurvenmaxima und -minima) ausgewertet werden kann. So werden weitere Informationen erhalten, die ein genaues Bestimmen der beobachteten Konzentration eines Stoffes ermöglichen und somit jederzeit auch eine Aussage über das aktuelle Stadium der chemischen Reaktion erlauben.

Die kontinuierliche Beobachtung des Verlaufs einer Reaktion mit dem erfindungsgemäßen Verfahren hat den weiteren Vorteil, daß Störquellen nahezu vollständig ausgeschaltet werden. In dem beobachteten Medium eventuell vorhandene weitere, farbige und nicht an der Reaktion beteiligte Stoffe oder trübende Verunreinigungen, die ein visuelles Erkennen einer Farbe erschweren, werden bei zeitabhängiger Messung als konstantes "Hintergrundrauschen" eliminiert.

Eine weitere Anwendung des erfindungsgemäßen Verfahrens ist die Bestimmung eines Farbtons, das heißt die Messung der Zusammensetzung einer Mischfarbe aus bekannten Farbstoffen. Dieses Problem tritt zum Beispiel bei der pH-Wertbestimmung mit Mischindikatoren auf. Doch auch bei anderen Verfahren, zum Beispiel der Bestimmung bestimmter Stoffe in der Analyse von Brauchwasser oder frei fließenden Gewässern werden Farbindikatoren verwendet, deren "Anzeige" erfindungsgemäß ausgewertet werden kann.

Im folgenden wird die Erfindung anhand zweier Ausführungsbeispiele und der Figuren 1 bis 3 näher erläutert. Dabei zeigt

Figur 1       eine Spektrometerdiode,
Figur 2       zeigt die Absorptionsbereiche der Einzeldioden der Spektrometerdiode und
in Figur 3    ist ein Versuchsaufbau zur Durchführung des er findungsgemäßen Verfahrens wiedergegeben.

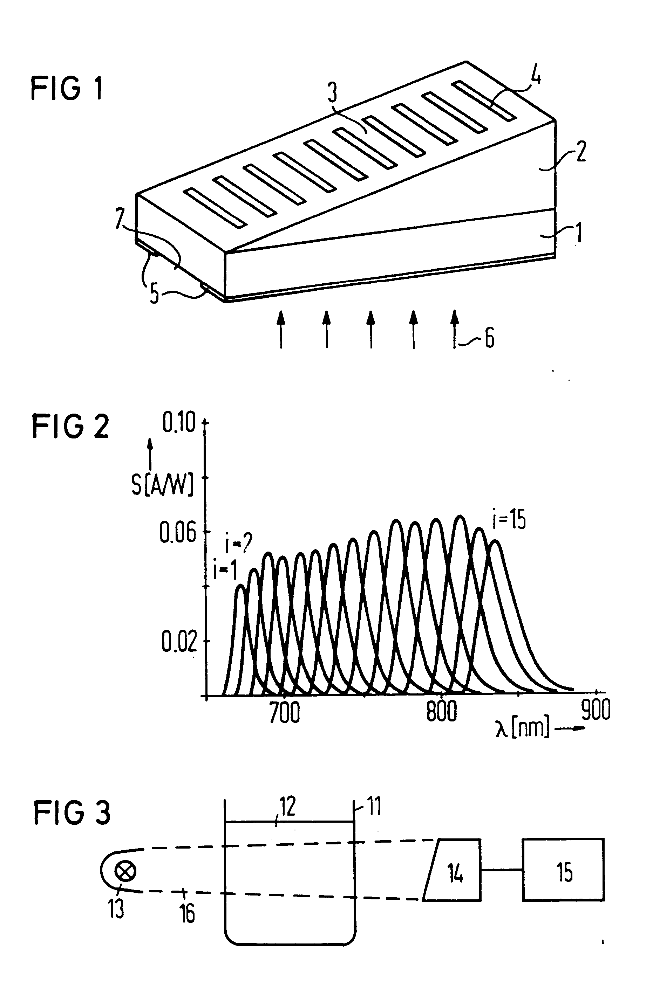

In Figur 1 ist eine Spektrometerdiode dargestellt. Diese enthält ein Substrat 1, das zum Beispiel aus Indiumphosphid besteht. Auf das Substrat 1 folgt ein Schichtaufbau 2, der zum Beispiel aus Indiumphosphid/Arsenid $InP_{1-x} As_x$ mit stetig veränderlichem x besteht, wobei x Werte zwischen 0 und 1 annimmt. Der Bandabstand im Mischkristall des Schichtaufbaus 2 nimmt vom Substrat 1 her stetig ab. Er verringert sich zum Beispiel von 1,3 eV im Substrat 1 (InP) auf 0,4 eV an der dem Substrat 1 abgewandten Seite des Schichtaufbaus 2 (InAs).

Die dem Substrat 1 abgewandte Oberfläche des Schichtaufbaus 2 weist eine schiefe Ebene 3 auf. Darauf aufgebrachte Schottky-Kontakte 4 bilden lichtempfindliche pn-Übergänge, die bei Betrieb der Spektrometerdiode in Sperrichtung gepolt sind. Auf der schiefen Ebene 3 steht durch den Schrägschliff jeder der Kontakte 4 mit einer ganz bestimmten Schicht des darunterliegenden Schichtaufbaus 2 in Verbindung, die einen spezifischen Bandabstand aufweist.

Auf der dem Schichtaufbau 2 gegenüberliegenden Oberfläche des Substrats 1 ist ein ohmscher Kontakt 5 angebracht, der Aussparungen aufweist, damit einfallendes Licht 6 in die Spektrometerdiode von der Substratseite 1 her eindringen kann. Das Licht 6 dringt so tief in den Schichtaufbau 2 ein, bis es in einer Schicht absorbiert werden kann, die einen der Wellenlänge des Lichts entsprechenden Bandabstand aufweist.

Figur 2 : Jeder der Kontakte 4 verhält sich mit dem darunterliegenden Schichtaufbau wie eine unabhängige Photodiode. Da die darunterliegenden Schichten jeweils unterschiedlichen Bandabstand aufweisen, absorbiert auch jede der "Einzeldioden" in einem eigenen Wellenlängenbereich. Die in Figur 2 dargestellten Kurven stellen die Empfindlichkeit der Einzeldioden gegenüber dem Licht verschiedener Wellenlängen dar. In der Figur ist die "Stärke" S des von der jeweiligen Einzeldiode abzugebenden Signals gegen die Wellenlänge $\lambda$ des einfallenden Lichts aufgetragen. Wie aus der Figur zu erkennen ist, überlappen dabei die Empfindlichkeitsbereiche der mit 1 bis 15 durchnumerierten Einzeldioden. Eine höhere Nummer bedeutet eine Empfindlichkeit für höhere Wellenlängen und entspricht gleichzeitig einer Diode mit niedrigerem Bandabstand. Jede Einzeldiode liefert beim Meßvorgang ein Signal, das dem im Empfindlichkeitsbereich der Diode absorbierten Licht entspricht. Mit den Einzelsignalen wird ein Muster erhalten, das ein aufgerastertes Bild der Spektralverteilung des gesamten von der Spektrometerdiode empfangenen und absorbierten Lichts wiedergibt.

## 1. Ausführungsbeispiel :

In Figur 3 ist eine Vorrichtung zur Durchführung des erfindungsgemäßen Verfahrens dargestellt. Ein lichtdurchlässiges und zum Beispiel aus Glas bestehendes Gefäß 11 ist mit dem zu beobachtenden Medium, zum Beispiel einer Lösung 12, gefüllt. Auf der einen Seite des Gefäßes 11 befindet sich eine Lichtquelle 13, deren Strahlengang 16 das Gefäß 11 und Teile der Lösung 12 durchstrahlt. Auf der anderen Seite des Gefäßes 11 befindet sich die Meßvorrichtung 14, zum Beispiel die oben erwähnte Spektrometerdiode, die mit einer Auswerteeinheit 15 verbunden ist. Von der Lösung (Medium) 12 soll nun der pH-Wert bestimmt werden. Dazu wird der Lösung ein Mischindikator zugegeben, der danach eine dem pH-Wert entsprechende Färbung annimmt. Mit der Lampe 13 wird nun das die Lösung 12 enthaltende Gefäß 11 beleuchtet. Beim Durchdringen des Mediums 12 werden vom Indikatorsystem bestimmte Frequenzen aus dem Licht absorbiert. Das von der Spektrometerdiode 14 nach Durchgang durch Gefäß 11 und Lösung 12 empfangene Licht hat eine für die Indikatorfarbe charakteristische Spektralverteilung. Die Einzeldioden der Spektrometerdiode 14 liefern nun Signale, die in der Auswerteeinheit 15 anhand ihres Musters ausgewertet werden. Das an sich bekannte Prinzip der Mustererkennung stützt sich auf Daten, die in einem Eichvorgang ermittelt und in der Auswerteeinheit 15 gespeichert werden. Diese Daten enthalten eine Vielzahl von Einzelmustern, die nun mit dem aktuellen Muster verglichen und so zugeordnet werden. Als Ergebnis liefert die Auswerteeinheit den pH-Wert der Lösung 12. Voraussetzung für dieses Verfahren ist, daß für Eich- und Meßvorgang die gleiche Lampe 13 und das gleiche Gefäß 11 verwendet werden. Die genaue Anordnung von Gefäß 11, Lampe 13 und Spektrometerdiode 14 zueinander ist ohne Bedeutung, und kann zwischen Eichvorgang und Meßvorgang noch variiert werden, da das gemessene Muster nicht von diesen Parametern beeinflußt wird. Dies hat den weiteren Vorteil, daß für das Meßverfahren lediglich eine sehr einfache Optik erforderlich ist. Es läßt sich somit einfach und schnell durchführen.

## 2. Ausführungsbeispiel :

Für einige Probleme kann es notwendig sein, das zu beobachtende System von dem Farbindikator zu trennen. Zum Beispiel können Farbindikatoren verwendet werden, die auf festen Trägern aufgebracht sind. Dies kann zum Beispiel ein Einzelindikator, ein Mischindikator oder mehrere verschiedene in räumlich voneinander getrennten Bereichen auf dem Träger aufgebrachte Einzelindikatoren sein. Der letzte Fall ist in einer Vielzahl von Teststreifen verwirklicht, wie sie zum Beispiel bei Wasser-oder Urinuntersuchungen in der Wasseranalytik und in der medizinischen Diagnostik verwendet werden. Zur Durchführung des erfindungsgemäßen Verfahrens wird ein solcher Teststreifen während einer vorgegebenen Zeitspanne mit dem Medium 12 in Kontakt gebracht, welches den zu beobachtenden Stoff enthält. Dies kann zum Beispiel durch Eintauchen des Streifens in die zu beobachtende Lösung 12 geschehen. Durch den Kontakt mit dem zu beobachtenden bzw. zu messenden Stoff erfolgt auf dem Teststreifen die Indikatorreaktion. Die Indikator enthaltenden Bereiche nehmen eine charakteristische Färbung an. Mit einer Lampe wird nun der aus der Lösung herausgenommene Teststreifen beleuchtet und das reflektierte Licht mit einer Spektrometerdiode gemessen. Das für die Indikatorfärbung charakteristische und von den Einzeldioden der Spektrometerdiode ermittelte Muster wird nun einer Auswerteeinheit zugeführt und mit den gespeicherten Werten aus einer Eichmeßreihe verglichen. Die Auswerteeinheit erkennt übereinstimmende Muster und liefert als Ergebnis die Konzentration des zu messenden Stoffes.

Mit dem erfindungsgemäßen Verfahren gestaltet sich die Konzentrationsbestimmung durch Erkennung der Indikatorfarbe einfach, ist schnell durchzuführen und läßt sich vor allem exakt reproduzieren. Der Meßaufbau ist einfach, die notwendigen Geräte sind handlich und leicht zu transportieren. Somit wird der Einsatz des erfindungsgemäßen Verfahrens auch außerhalb eines Labors zum Beispiel in der freien Natur ermöglicht.

## Patentansprüche

1. Verfahren zur optischen Bestimmung der Konzentration mindestens eines Stoffes, welche direkt über eine Eigenfarbe des oder der Stoffe oder indirekt mit Hilfe eines Farbindikators in einem Medium beobachtbar ist, **dadurch gekennzeichnet,** daß das von dem die Farbe anzeigenden Medium abgegebene Licht mittels mehrerer, in unterschiedlichen Absorptionsbereichen empfindlicher unabhängiger Photodioden gemessen wird, die Meßwerte dann in einer Mustermatrix zusammengefaßt werden, in an sich bekannter Weise nach dem Prinzip der Mustererkennung ausgewertet werden und so anhand bekannter Vergleichswerte die Konzentration des oder der Stoffe ermittelt wird.

2. Verfahren nach Anspruch 1, **dadurch gekennzeichnet,** daß Photodioden verwendet werden, die auf einem einzigen elektrischen Bauteil integriert sind.

3. Verfahren nach Anspruch 1 und 2, **dadurch gekennzeichnet,** daß als integriertes Bauteil eine Spektrometerdiode verwendet wird.

4. Verfahren nach einem der Ansprüche 1 bis 3, **dadurch gekennzeichnet,** daß das die Farbe aufweisende Medium eine Lösung ist, die zumindest zum Teil von dem Licht einer konstanten Strahlungsquelle durchstrahlt wird, und daß dieses Licht von den Photodioden "hinter" der Lösung gemessen wird.

5. Verfahren nach einem der Ansprüche 1 bis 3, **dadurch gekennzeichnet,** daß ein auf einem festen Träger aufgebrachter Farbindikator verwendet wird, dieser während einer vorgegebenen Zeitspanne mit dem Medium in Kontakt gebracht wird, welches den zu beobachtenden Stoff enthält und dann die "Farbe" des Farbindikators mit den Photodioden bestimmt wird.

6. Verfahren nach mindestens einem der Ansprüche 1 bis 5, **dadurch gekennzeichnet,** daß es zur kontinuierlichen Beobachtung des Verlaufs einer chemischen Reaktion verwendet wird.

## Claims

1. Method for the optical identification of the concentration of at least one substance, which can be observed in a medium directly due to an inherent colour of the substance or substances or indirectly using a colour indicator, characterised in that the light emitted by the medium which indicates the colour is measured by means of a plurality of independent photodiodes which are sensitive in different absorption regions, the measured values are then combined in a pattern matrix and are evaluated in a manner known per se in accordance with the principle of pattern recognition, and the concentration of the substance or substances is thus identified using known comparison values.

2. Method according to Claim 1, characterised in that photodiodes are used which are integrated on a single electrical component.

3. Method according to Claims 1 and 2, characterised in that a spectrometer diode is used as the integrated component.

4. Method according to one of Claims 1 to 3, characterised in that the medium that has the colour is a solution which is at least partially transirradiated by the light from a constant radiation source, and in that this light is measured by the photodiodes "behind" the solution.

5. Method according to one of Claims 1 to 3, characterised in that a colour indicator applied to a solid carrier is used, the latter is brought into contact with the medium during a predetermined time interval, said medium containing the substance to be observed, and the "colour" of the colour indicator is then identified by the photodiodes.

6. Method according to at least one of Claims 1 to 5, characterised in that it is employed for the continuous observation of the course of a chemical reaction.

## Revendications

1. Procédé de détermination optique de la concentration d'au moins une substance, qui peut être observée directement par une couleur propre de la ou des substances, ou indirectement à l'aide d'un indicateur coloré dans un milieu, caractérisé en ce qu'il consiste à mesurer la lumière émise par le milieu indiquant la couleur au moyen de plusieurs photodiodes indépendantes, sensibles à des domaines d'absorption différents, à réunir ensuite les valeurs mesurées dans une matrice modèle exploitée d'une manière en soi connue, suivant le principe de la reconnaissance d'un modèle, et à déterminer ainsi, au moyen de valeurs comparatives connues, la concentration de ou des substances.

2. Procédé suivant la revendication 1, caractérisé en ce qu'il consiste à utiliser des photodiodes qui sont intégrées sur un composant électrique unique.

3. Procédé suivant la revendication 1 ou 2, caractérisé en ce qu'il consiste à utiliser, comme composant intégré, une diode formant spectromètre.

4. Procédé suivant l'une des revendications 1 à 3, caractérisé en ce que le milieu présentant la couleur est une solution à travers laquelle passe, au moins en partie, la lumière d'une source de rayonnement constante et cette lumière est mesurée par les photodiodes "derrière" la solution.

5. Procédé suivant l'une des revendications 1 à 3, caractérisé en ce qu'il consiste à utiliser un indicateur coloré déposé sur un support solide, à le mettre en contact pendant un laps de temps prescrit avec le milieu qui contient la substance à observer, et à déterminer ensuite la "couleur" de l'indicateur coloré avec les photodiodes.

6. Procédé suivant l'une au moins des revendications 1 à 5, caractérisé en ce qu'il est utilisé pour l'observation en continu du déroulement d'une réaction chimique.

FIG 1

FIG 2

FIG 3